# EUROPÄISCHE PATENTSCHRIFT

(11) **EP 3 053 186 B1**
(45) Veröffentlichungstag und Bekanntmachung des Hinweises auf die Patenterteilung: **26.05.2021**
(21) Anmeldenummer: 14776891.5
(22) Anmeldetag: 29.09.2014
(51) Int. Cl.: H01L 21/67, H01L 21/677, C25F 3/12, C25F 3/14, C25F 7/00

(54) **VORRICHTUNG UND VERFAHREN ZUR KONTINUIERLICHEN HERSTELLUNG PORÖSER SILICIUMSCHICHTEN**
DEVICE AND METHOD FOR THE CONTINUOUS PRODUCTION OF POROUS SILICON LAYERS
DISPOSITIF ET PROCÉDÉ DE PRODUCTION EN CONTINU DE COUCHES DE SILICIUM POREUSES

(30) Priorität: 01.10.2013 DE 102013219886
(43) Veröffentlichungstag der Anmeldung: 10.08.2016
(73) Patentinhaber: Fraunhofer-Gesellschaft zur Förderung der angewandten Forschung e.V., 80686 München (DE)
(72) Erfinder: REBER, Stefan, 79194 Gundelfingen (DE); LINDEKUGEL, Stefan, 79211 Denzlingen (DE); PAVLOVIC, Regina, 79102 Freiburg (DE); JANZ, Stefan, 79106 Freiburg (DE)
(74) Vertreter: Pfenning, Meinig & Partner mbB
(86) Internationale Anmeldenummer: PCT/EP2014/070804
(87) Internationale Veröffentlichungsnummer: WO 2015/049205

(56) Entgegenhaltungen:
- EP-A2- 1 059 663
- EP-A2- 2 060 659
- WO-A1-02/075800
- WO-A1-2010/083422
- WO-A1-2011/108463
- DE-A1-102006 033 353
- DE-B3-102008 026 199

## Beschreibung

Die Erfindung betrifft eine Vorrichtung und ein Verfahren zur kontinuierlichen Herstellung poröser Siliciumschichten (Einfach- oder Mehrfachschichten) auf Werkstücken aus Silicium oder Werkstücken mit einer Silicium-Beschichtung. Das erfindungsgemäße Verfahren basiert dabei auf einem einseitigen Ätzverfahren, wobei das Werkstück mittels einer Transportvorrichtung horizontal mit der zu ätzenden Frontseite des Werkstücks an mehr als einer Ätzkammer enthaltend einen Elektrolyten und eine Kathode vorbeigeführt wird. Dieses Verfahren kann insbesondere für die Herstellung von PV-Zellen eingesetzt werden.

Poröses Silicium ist ein vor allem in der Mikrosystemtechnik verwendetes Material und wird zum Beispiel von Sensoren verwendet. Für die Photovoltaik ist poröses Silicium für verschiedene Anwendungen untersucht worden, zum Beispiel als Multilagenschicht für Bragg-Reflektoren oder als mechanisch schwache Doppellagenschicht als Nukleationsschicht für Epitaxie-Prozesse mit anschließendem Ablösen.

Die Herstellung einer Schicht aus porösem Silicium erfolgte anfangs mittels stromlosem Ätzen. Hierzu sind zwei verschiedene Verfahren zum Beispiel in den Druckschriften DE 10 2005 062 528 A1 und DE 103 13 127 B4 beschrieben.

In der DE 103 13 127 B4 wird ein Verfahren beschrieben, bei dem die Unterseite des Wafers mit der Ätzlösung in Kontakt gebracht wird, es bildet sich ein Meniskus. Die Waferunterseite ist über die gesamte Prozesszeit kontinuierlich in Kontakt mit der Ätzlösung. In der DE 10 2005 062 528 A1 wird ein Verfahren beschrieben, bei dem kein kontinuierlicher Kontakt zwischen der Waferunterseite und der Ätzlösung besteht. Die Ätzlösung wird durch eine besondere Profilierung der sich drehenden Transportwalzen an die Waferunterseite gebracht, während gleichzeitig der Wafer horizontal fortbewegt wird. An der Waferunterseite bildet sich ein Flüssigkeitsfilm aus.

Durch die Ätzreaktion entstehen unter anderem Stickoxide ("NOₓ"-Gase), die zum Teil in der Ätzlösung gelöst sind, zum Teil in den Gasraum der Prozessmodule gelangen. Stickoxide in Verbindung mit Flusssäure-Dämpfen haben eine ätzende Wirkung auf Silizium, insbesondere auf hochdotiertes Silizium, wie es der Emitter ist, und durch den HF-Anteil ebenfalls auf Phosphorsilikatglas oder Borsilikatglas. Um eine unerwünschte (weil ungleichmäßige) Anätzung der Emitterseite zu vermeiden, werden die Reaktionsdämpfe aus dem Prozessraum abgesaugt bzw. Zusätze zum Prozessmedium eingesetzt, um Gasbildung zu vermeiden.

In der DE 10 2009 050 845 A1 ist ein Verfahren beschrieben, bei dem auf die Waferoberseite vor dem einseitigen Ätzvorgang eine definierte Wassermenge auf den Wafer aufgetragen wird. Das Wasser breitet sich über die hydrophile Waferoberfläche (mit Phosphor- oder Bor-silikatglas) aus und bildet so eine Schutzschicht gegen die ätzenden Dämpfe.

In der DE 10 2008 037 404 A1 ist ein einseitiges Ätzverfahren beschrieben, in dem die Zusammensetzung der Gasphase über dem Prozessmedium in der Weise beeinflusst wird, dass die Oberfläche während des Kantenisolationsprozesses hydrophobisiert wird, bzw. nach vorheriger Behandlung in verdünnter Flusssäure hydrophob bleibt. Es werden nur saure Medien beschrieben.

Es ist ebenfalls möglich, die Reaktionsdämpfe zu einer absichtlichen Emitterrückätzung zu verwenden. Ein solches Verfahren ist in der WO2011/035748 A1 beschrieben. Damit die Emitterseite möglichst homogen geätzt wird, werden die Reaktionsdämpfe entsprechend abgesaugt, oder es wird ein Inertgas der Gasphase über dem Prozessmedium zusätzlich zugeführt oder es wird ein Reaktivgas wie HF oder Ozon zusätzlich zugeführt. Optional wird für die Rückätzung des Emitters ein zusätzlicher Ätzschritt, vorzugsweise mit HF und Ozon, als Lösung oder in der Gasphase, zur besseren Einstellbarkeit des Rückätzprozesses angegeben. Eine gleichmäßige kontrollierte Rückätzung des Emitters ist erwünscht, weil durch die Entfernung von hochdotierten obersten Emitterschichten die Oberflächenrekombination der erzeugten Ladungsträger reduziert und der Wirkungsgrad der Solarzellen so verbessert wird. Üblicherweise werden die Kantenisolation und die Emitterrückätzung in zwei getrennten Prozessmodulen mit unterschiedlichen Ätzlösungen durchgeführt. Die vorgeschlagenen Ätzmedien sind sauer.

Das stromlose Ätzen wurde in der letzten Zeit fast vollständig durch elektrochemisches Ätzen in einem Flusssäure und Ethanol enthaltenden Elektrolyten ersetzt. In allen Fällen des elektrochemischen Ätzens werden die Kathode und die Anode mit den beiden Waferflächen kontaktiert, was entweder direkt durch einen Metall-Halbleiter-Kontakt oder indirekt über einen Metall/Graphit-Elektrolyt-Halbleiter-Kontakt erfolgen kann. Eine weitere aus dem Stand der Technik bekannte Variante sieht vor, dass eine Kontaktierung einer der beiden Elektroden am Rand des Wafers erfolgt

Eine Vorrichtung zum elektrochemischen Ätzen ist etwa in der WO2011110682 A2 gezeigt.

Alle für Wafergeometrien geeignete Anlagen haben dabei die Schwäche gemein, dass der Wafer nicht oder nur mit großem Aufwand vollflächig geätzt werden kann. Erfolgt die Kontaktierung am Rand, zum Beispiel über eine Klemme, muss prinzipbedingt der kontaktierte Bereich des Wafers ungeätzt bleiben. Erfolgt hingegen die Kontaktierung über die Fläche, ist der Wafer bzw. der Elektrolytkontakt an mindestens einer Seite mit einem Dichtungsring versehen, um ein Austreten des Elektrolyts sowie einen Kurzschluss zu verhindern. Was zusätzlich zu einem verminderten Durchsatz führt ist, dass der toxische Elektrolyt vor dem Waferwechsel erst aufwendig entfernt werden muss.

Für ein Verfahren zur Herstellung von porösem Silicium ist es daher angestrebt, wenn die geätzte Fläche komplett einseitig sogar ohne Umgriff auf die Kante des Wafers ist. Essentiell notwendig für eine Anwendung für Flächenbauelemente, wie z.B. Solarzellen, ist hierfür eine Apparatur, welche sehr hohe Durchsätze ermöglicht. In der Photovoltaik verwendete Prozessanlagen für zum Beispiel nasschemische Prozesse haben derzeit Durchsätze von einigen 1000 Wafern pro Stunde.

Ein weiteres Problem besteht darin, dass die verwendeten Elektroden aus Korrosionsschutzgründen aus einem Edelmetall, in der Regel Platin, oder höchstverdichtetem Kohlenstoff (sog. glassy carbon) bestehen müssen. Die bestehenden Anlagen sind alle auf flächige Elektroden ausgelegt, da die stationär gehaltenen Wafer aus Gründen der Schichthomogenität mit möglichst homogenem elektrischem Feld geätzt werden müssen. Für Hochdurchsatzanlagen sind die benötigten Mengen an Elektrodenmaterial ein starker Kostentreiber, was bis zur Unwirtschaftlichkeit des Prozesses führen kann.

Stationäre bzw. in mitlaufenden Behältern stattfindende Verfahren zur Herstellung poröser Siliciumschichten haben als weitere Herausforderung das elektrische Abschatten der zu ätzenden Oberfläche durch gebildete Wasserstoffbläschen. Dieses Problem wird üblicherweise durch starke Elektrolytkonvektion oder durch vertikale Prozessanordnung gelöst.

Ausgehend von den im Stand der Technik auftretenden Problemen war es Aufgabe der vorliegenden Erfindung, ein Verfahren zur vollflächigen einseitigen Herstellung von porösem Siliciumschichten bereitzustellen, bei dem nur ein vernachlässigbar kleiner Kantenumgriff erfolgt und keine Separation der Kontaktelektroden durch Dichtungsringe erforderlich ist. Eine weitere Aufgabe der vorliegenden Erfindung ist es, die Skalierfähigkeit einer entsprechenden Vorrichtung herzustellen und die einfache Durchführung von Multilagen-Ätzprozessen zu ermöglichen.

Diese Aufgabe wird durch die Vorrichtung mit den Merkmalen des Anspruchs 1 und das Verfahren mit den Merkmalen des Anspruchs 8 gelöst. Die weiteren abhängigen Ansprüche zeigen vorteilhafte Weiterbildungen auf. In Anspruch 15 werden erfindungsgemäße Verwendungen angegeben.

Erfindungsgemäß wird eine Vorrichtung zur kontinuierlichen Herstellung poröser Siliciumschichten auf Werkstücken aus Silicium oder Werkstücken mit einer Silicium-Beschichtung mittels einseitigem Ätzen bereitgestellt, die folgende Komponenten enthält:
- mindestens eine Transportvorrichtung für den kontinuierlichen Transport des Werkstücks,
- mehr als eine einen Elektrolyten und eine Kathode enthaltende Ätzkammer, die so angeordnet ist, dass nur eine zu ätzende Oberfläche des Werkstücks mit dem Elektrolyten benetzbar ist, sowie
- eine mit dem Werkstück an einer nicht zu ätzenden Oberfläche über eine Kontakteinheit elektrisch kontaktierte Anode, wobei die Ätzkammern unterhalb des Werkstücks angeordnet sind.

Gemäß dem Stand der Technik wurden bislang Ätzkammer immer oberhalb des Werkstücks angeordnet, damit sich bildende Bläschen nach oben abgeführt werden können, um eine Inhomogenität bei der Beschichtung zu vermeiden. Überraschenderweise konnte festgestellt werden, dass durch den Probentransport sowie teilweise auch durch die erzwungene Konvektion des Elektrolyten in der Ätzkammer gemäß der erfindungsgemäßen Anordnung ein Absätzen von Bläschen auf der zu ätzenden Seite des Werkstücks unterblieb, so dass eine homogene Ätzung ermöglicht wird. Hierdurch wird die Verwendung einer kostengünstiger Ätzkammer möglich, da eine aufwendige Abdichtung wie im Stand der Technik, bei dem die Ätzkammer oberhalb des Werkstücks angeordnet sind, unterbleiben kann. Ein weiterer Vorteil dieser erfindungsgemäßen Variante besteht darin, dass auch diskrete Werkstücke, die jeweils beabstandet zueinander transportiert werden, bearbeitet werden können, während gemäß dem Stand der Technik nur Endlos-Werkstücke einsetzbar sind. Ein weiterer Vorteil besteht darin, dass diese erfindungsgemäße Variante neue Möglichkeiten hinsichtlich der Werkstückgeometrie ermöglicht. Während bei einer Anordnung der Ätzkammer oberhalb des Werkstücks die Breite des ablaufenden Bandes in engen Grenzen vorgegeben ist, ist die Breite der Werkstücke beim erfindungsgemäßen Verfahren sehr variabel. Ein weiterer Vorteil besteht darin, dass durch die erfindungsgemäße Anordnung der Ätzkammer unterhalb des Werkstücks keine expliziten Dichtflächen vorhanden sind, sondern im Gegenteil eine Beabstandung zwischen Elektrolytbehälter und zu ätzender Werkstückseite einstellbar ist. Dieser Spalt wird durch einen durch Pumpen betriebenen Überlauf des Elektrolyten geschlossen. Dies ermöglicht auch den Zugang zu Werkstücken mit einer rauen oder welligen bzw. gebogenen Oberfläche.

Für die Werkstücke mit einer Silicium-Beschichtung kann das Werkstück selber aus beliebigen Materialien gewählt werden. Die Werkstoffe können dabei bevorzugt eine Dicke zwischen 50 µm und 500 mm aufweisen, wobei das Werkstück sowohl als Wafer oder auch als massive Bramme vorliegen kann. Dabei ist das Werkstück, insbesondere aus Silicium, bevorzugt hochdotiert mit einem spezifischen Widerstand unter 0,1 Ω cm.

Die erfindungsgemäße Vorrichtung erlaubt somit ein Herstellungsverfahren für poröse Siliciumschichten, bei denen Werkstücke im Durchlauf elektrochemisch geätzt werden. Die Ätzung erfolgt dabei einseitig und bevorzugt vollflächig. Die erfindungsgemäße Vorrichtung kann dabei auf Anlagen basieren, die für eine einseitige Prozessierung von Werkstücken bei hohen Durchlaufraten, z.B. Durchlauf-Galvanikanlagen, eingesetzt werden.

Ein weiterer wichtiger Vorteil der erfindungsgemäßen Vorrichtung beruht darauf, dass auf Dichtelemente am Werkstück vollständig verzichtet werden kann, was ein einfacheres Handling der Anlage zulässt.

Die erfindungsgemäße Vorrichtung ermöglicht dabei sehr homogen dicke poröse Siliciumschichten, da die Inhomogenitäten in der Ätzstromdichte in Transportrichtung ausgeglichen werden, da diese Inhomogenitäten von jedem Punkt des Werkstücks durchlaufen und dadurch ausgemittelt werden.

Vorzugweise wird als Kathode eine flächige Elektrode oder ein Elektrodendrahtnetz eingesetzt. Es ist aber ebenso möglich, einen einzelnen Elektrodendraht als Kathode zu verwenden, der vorzugsweise senkrecht zur Transportrichtung angeordnet wird. Das Material der Kathode besteht dabei vorzugsweise aus Platin, Nickellegierungen und/oder Glaskohlenstoff (glassy carbon).

Der Abstand der Kathode zur zu ätzenden Oberfläche des Werkstücks ist dabei bevorzugt im Bereich von 1 bis 500 mm, besonders bevorzugt im Bereich von 10 bis 100 mm gewählt.

Die mindestens eine Anode ist vorzugsweise als Schleifkontakt, abrollender Kontakt oder mitlaufender Kontakt ausgebildet. Dabei ist das Material der mindestens einen Anode bevorzugt aus Platin, Nickellegierungen, korrosionsfestem Edelstahl, Titan, Aluminium, Graphit und/oder Glaskohlenstoff.

Eine weitere bevorzugte Ausführungsform sieht vor, dass die Kontakteinheit der mindestens einen Anode mit einem Schutzgas gespült wird. Als Schutzgas wird hier vorzugsweise Luft oder Stickstoff eingesetzt. Auf diese Weise wird es ermöglicht, dass das freiliegende Kontaktmaterial nicht mit Elektrolytdämpfen oder Reaktionsdämpfen in Verbindung kommt. Diese Variante ist insbesondere dann sinnvoll, wenn Elektrolyten mit brennbaren Komponenten, z.B. brennbarem Tensid, verwendet werden.

Die erfindungsgemäße Vorrichtung kann vorzugsweise mit anderen Konditionierungs- oder Nachbehandlungseinheiten gekoppelt werden. Hierbei handelt es sich insbesondere um Einheiten zur Oberflächenbehandlung, zum Spülen oder zum Trocknen. Hierbei kann es sich insbesondere um eine stromlose Schadensätze zur Oberflächenvorbereitung des Werkstücks oder um Reinstwasser-Spüleinheiten bzw. Trocknungseinheiten zur Nachbehandlung des Werkstoffs handeln.

In einer bevorzugten Ausführungsform ist die erfindungsgemäße Vorrichtung mit einer weiteren Einheit zur thermischen Reorganisation der porösen Siliciumschicht gekoppelt. Eine derartige Einheit zur thermischen Reorganisation weist vorzugweise eine Temperatur- oder Leistungssteuerung für das Tempern des Werkstoffs auf. Ebenso enthält sie vorzugsweise eine Vorrichtung zur Erzeugung einer kontrollierten Gasatmosphäre zumindest auf den beheizten Teilen der Frontseite. Dies kann beispielsweise durch Gasschleusen realisiert werden. Die Einheit zur thermischen Reorganisation weist vorzugsweise flächige oder fokussierte Lampen zur Einstellung der für die Reorganisation erforderlichen Temperatur in der porösen Siliciumschicht auf. Die Lampen sind dabei vorzugsweise ausgewählt aus der Gruppe der Halogenlampen, LED-Lampen oder Halbleiterlaser.

Bei einer weiteren bevorzugten Ausführungsform des Verfahrens ist das Werkstück eine planare Scheibe, insbesondere aus Silicium, mit einer Fronseite und einer Rückseite und die Transportvorrichtung bewirkt einen horizontalen Transport der planaren Scheibe, wobei die zu ätzende Oberfläche die Frontseite der planaren Scheibe ist und die nicht im Kontakt mit dem Elektrolyten stehende Rückseite über die Kontakteinheit mit der Anode elektrisch kontaktiert ist.

Bei der Transportvorrichtung handelt es sich vorzugsweise um ein Rollentransport, einen Luft-/Flüssigkeitskissentransport oder ein Durchschubtransport.

Eine weitere erfindungsgemäße Ausführungsform sieht vor, dass das Werkstück ein Zylinder ist, insbesondere ein Silicium-Ingot, und die Transportvorrichtung eine Rotation des Zylinders bewirkt, wobei die zu ätzende Oberfläche die Mantelfläche des Zylinders ist und der Zylinder an einer nicht zu ätzenden Oberfläche über die Kontakteinheit mit der Anode elektrisch kontaktiert ist.

Dabei ist es bevorzugt, dass die Kathode eine konkave Oberfläche aufweist, wobei die Krümmung der konkaven Oberfläche der Kathode an die Krümmung der Manteloberfläche des Zylinders so angepasst ist, dass die Kathode einen einheitlichen Abstand zur Manteloberfläche des Zylinders aufweist.

Erfindungsgemäß wird ebenso ein Verfahren zu kontinuierlichen Herstellung poröser Siliciumschichten auf Werkstücken aus Silicium oder Werkstücken mit einer Silicium-Beschichtung mittels einseitigem Ätzen bereitgestellt, bei dem mindestens ein Werkstück mittels mindestens einer Transportvorrichtung mit der zu ätzenden Oberfläche des Werkstücks an mehr als einer einen Elektrolyten und eine Kathode enthaltenden Ätzkammer vorbeigeführt wird, wobei nur die zu ätzende Oberfläche mit dem Elektrolyten benetzt wird und das Werkstück an einer nicht zu ätzenden Oberfläche über eine Kontakteinheit mit einer Anode elektrisch kontaktiert wird, wodurch ein elektrochemisches Ätzen der Oberfläche ermöglicht wird, wobei die Ätzkammern unterhalb des Werkstücks angeordnet sind.

Dabei ist es bevorzugt, dass das elektrochemische Ätzen mit einem Ätzstrom von 0,1 bis 1000 mA/cm², bevorzugt von 5 bis 500 mA/cm² durchgeführt wird.

Vorzugsweise werden die mehr als eine Ätzkammern mit unterschiedlich großen Ätzströmen und/oder unterschiedlichen Elektrolytmischungen betrieben, um Mehrfachschichtsysteme mit unterschiedlichen Porositäten und Dicken herstellen zu können.

Weiterhin bevorzugt können die mehr als eine Ätzkammern mit gleich großen Ätzströmen und gleichen Elektrolytmischungen betrieben werden, um dickere Schichten herzustellen oder den Durchsatz der Anlage zu erhöhen.

Der Elektrolyt enthält vorzugsweise Flusssäure und mindestens einen Alkohol oder ein Tensid, insbesondere Ethanol, Acetonitrid, Dimethylsulfoxid, Dimethylacetamid, Dimethylformamid, Formamid, Essigsäure und Gemische aus Tensiden z.B. Siloxanen und Polyalkylenoxidcopolymere. Es können aber auch weitere Zusätze enthalten sein.

Vorzugsweise erfolgt eine Konvektion des Elektrolyten, um eine Blasenbildung zu vermeiden.

In einer bevorzugten Ausführungsform des erfindungsgemäßen Verfahrens werden die Werkstücke zur Erzeugung von Elektronen-Fehlstellen (Löchern) mit Licht bestrahlt, wobei das Licht eine Wellenlänge von 200 nm und 1200 nm, besonders bevorzugt zwischen 400 nm und 1100 nm aufweist. Vorzugsweise erfolgt das einseitige Ätzen des Werkstücks vollflächig.

Die zuvor beschriebene erfindungsgemäße Vorrichtung wird zur Herstellung von photovoltaischen Zellen oder Elektroden für Si-Li-Batterien oder Si-Luft-Batterien eingesetzt.

Anhand der nachfolgenden Figuren und Beispiele soll der erfindungsgemäße Gegenstand näher erläutert werden, ohne diesen auf die hier gezeigten spezifischen Ausführungsformen einschränken zu wollen.

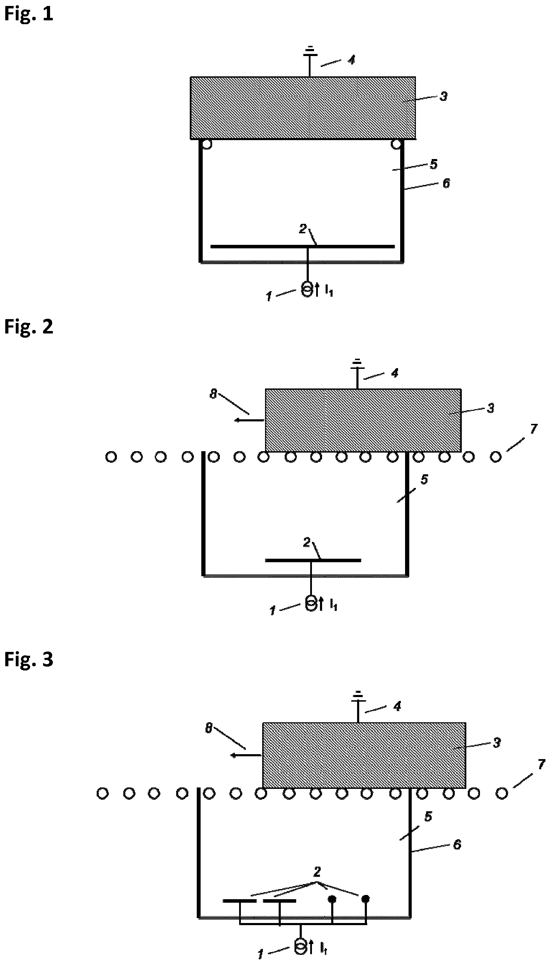

Fig. 1 zeigt eine Ausführungsform des Stands der Technik: die Ätzeinheit besteht aus dem Elektrolytbehälter 6, der Kathode 2, sowie der Stromquelle 1. An die Ätzeinheit ist das Werkstück 3, typischerweise ein Siliciumwafer, z.B. durch O-Ringe angedichtet. Die Anode 4 kontaktiert das Werkstück, entweder direkt über einen Festkörperkontakt (z.B. Platin), oder indirekt über einen (nicht dargestellte) weiteren Elektrolyt-Behälter. Zum Herstellen der porösen Siliciumschicht wird dem Werkstück über die Kathode 2 und die Anode 4 ein Ätzstrom aufgeprägt, dessen Höhe und Dauer der Anzahl von Schichtlagen und der Porosität angepasst wird. Zur Herstellung einer porösen Silicium-Doppelschicht, die nach einer Reorganisation abgelöst werden kann, sind z.B. folgende Parameter geeignet:
- Schicht 1 (niederporöse Schicht, ca. 30% Porosität): 10 mA/cm² Ätzstromdichte, Ätzdauer 60 sec, Elektrolyt 50% Ethanol + 50% Flusssäure
- Schicht 2 (hochporöse Schicht, ca. 60% Porosität): 200 mA/cm² Ätzstromdichte, Ätzdauer 5 sec, Elektrolyt 50% Ethanol + 50% Flusssäure

Fig. 2 zeigt das Grundprinzip des erfindungsgemäßen Ätzers. Das Werkstück 3 ist nicht dicht an die Ätzeinheit angeschlossen, sondern wird mit einer geeigneten Transporteinrichtung 7 so gelagert, dass es im Kontakt mit dem Elektrolyten steht. Der Anodenkontakt 4 kann entweder fest als mitlaufender/mitrollender Kontakt, oder als Schleifkontakt ausgeführt sein. Eine eventuelle Schutzgasspülvorrichtung zur Vermeidung einer Zündquelle an der Anode ist in Fig. 2 nicht gezeichnet. Der Ätzvorgang wird folgendermaßen durchgeführt:
Dem Werkstück wird über die Kathode 2 und die Anode 4 ein Ätzstrom aufgeprägt. Der Flüssigkeitsspiegel des Elektrolyten 5 wird z.B. über eine geeignete Pumpvorrichtung, oder über eine definierte Eintauchtiefe so eingestellt, dass die zu ätzende Seite des Werkstücks mit dem Elektrolyten benetzt wird. Bevorzugt wird der Elektrolyt bewegt, so dass im Ätzvorgang entstehender Wasserstoff von der zu ätzenden Oberfläche abtransportiert wird. Während des Ätzvorgangs wird das Werkstück mit Hilfe der Transportvorrichtung 7 in einer Richtung 8 am Elektrolyten entlang bewegt. Durch die Bewegung werden eventuelle Inhomogenitäten in Transportrichtung ausgeglichen. Das Ätzen von Mehrfachschichten kann durch wiederholtes Überfahren der Ätzeinheit, entweder nach einem Rücktransport mit ausgeschalteter Ätzeinheit, oder durch eine Pendelbewegung mit eingeschalteter Ätzeinheit, durchgeführt werden. Durch Variation des Ätzstroms je Sequenz können Stapel unterschiedlicher Schichten erzeugt werden. Um Variationen des Ätzergebnisses beim Ein- und Ausfahren des Werkstücks zu vermeiden, kann der Ätzstrom dynamisch so angepasst werden, dass die auf das Werkstück einwirkende Ätzstromdichte zu jeder Zeit konstant bleibt.

Ein erfindungsgemäßer Ätzprozess kann beispielsweise folgendermaßen durchgeführt werden:
Das Werkstück wird außerhalb der Ätzeinheit bereitgestellt, und die zum Herstellen des Ätzstroms erforderliche Spannung an die Elektroden angelegt. Mit der Transporteinheit wird das Werkstück in Bewegung versetzt, und kontinuierlich über die Ätzeinheit hinweg bewegt. Die durch den Elektrolyten kontaminierte Oberfläche wird danach durch Spülen in deionisiertem Wasser dekontaminiert, und z.B. mit einem Gebläse oder durch Einwirkung von z.B. Infrarot- oder Mikrowellenstrahlung getrocknet.

Geeignete Ätzparameter sind:
- für eine niederporöse Schicht, ca. 30% Porosität): 10 mA/cm² Ätzstromdichte, Einwirkbereich der Elektroden in Transportrichtung 60 cm, Vorschubgeschwindigkeit 60 cm/min, Elektrolyt 50% Ethanol + 50% Flusssäure
- für eine hochporöse Schicht, ca. 60% Porosität): 200 mA/cm² Ätzstromdichte, Einwirkbereich der Elektroden in Transportrichtung 5 cm, Vorschubgeschwindigkeit 60 cm/min, Elektrolyt 50% Ethanol + 50% Flusssäure

Eine weitere erfindungsgemäße Vorrichtung zeigt die Fig. 3: Statt einer flächigen Kathode ist die Kathode hier aus mehreren elektrisch parallel geschalteten Einzelkathoden 2 angeordnet. In der Regel sind die Einzelkathoden senkrecht zur Transportrichtung über die Breite des Werkstücks entlang ausgedehnt, um eine zur Transportrichtung homogene Ätzrate zu gewährleisten.

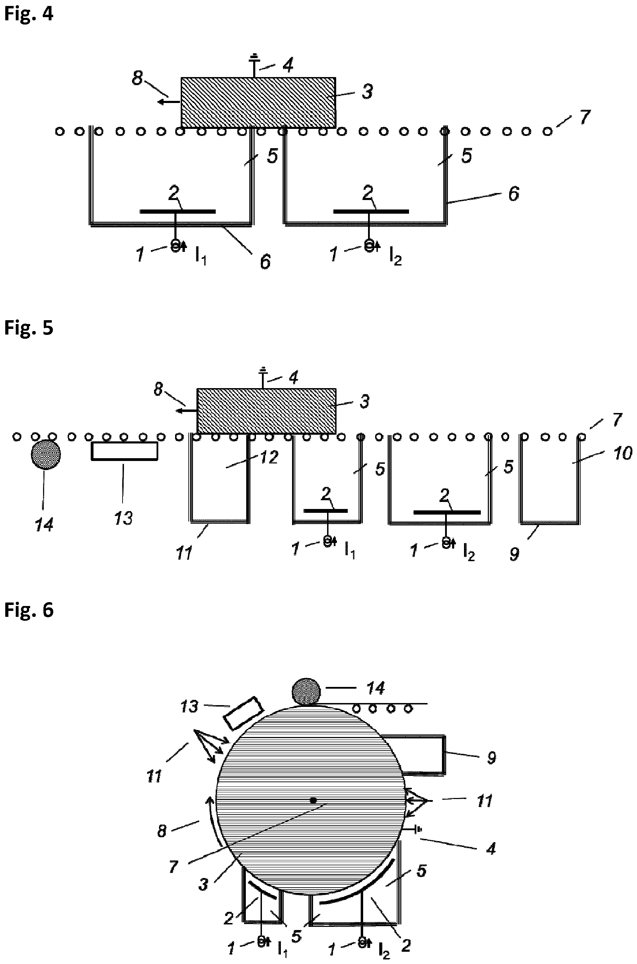

Die Fig. 4 zeigt eine Ausprägung der erfindungsgemäßen Vorrichtung mit mehreren sequentiell hintereinander geschalteten Ätzeinheiten (1, 2, 5, 6). Die einzelnen Ätzeinheiten sind unabhängig voneinander betreibbar, so dass Schichten unterschiedlicher Porosität und Dicke in einem Durchlauf hergestellt werden können.

Ein Ätzprozess zur Herstellung einer doppellagigen Schicht, die z.B. als nach einer thermischen Behandlung in Wasserstoff ablösbar ist, kann folgendermaßen durchgeführt werden:
Das Werkstück wird außerhalb der Ätzeinheit bereitgestellt, und die zum Herstellen des Ätzstroms erforderliche Spannung an die Elektroden sowohl der ersten, als auch der zweiten Ätzeinheit angelegt. Mit der Transporteinheit wird das Werkstück in Bewegung versetzt, und kontinuierlich über die Ätzeinheiten hinweg bewegt. Die durch den Elektrolyten kontaminierte Oberfläche wird danach durch Spülen in deionisiertem Wasser dekontaminiert, und z.B. mit einem Gebläse oder durch Einwirkung von z.B. Infrarot- oder Mikrowellenstrahlung getrocknet. Geeignete Ätzparameter sind:
- Ätzkammer 1 (für eine niederporöse Schicht, ca. 30% Porosität): 10 mA/cm² Ätzstromdichte, Einwirkbereich der Elektroden in Transportrichtung 60 cm, Vorschubgeschwindigkeit 60 cm/min, Elektrolyt 50% Ethanol + 50% Flusssäure
- Ätzkammer 2 (für eine hochporöse Schicht, ca. 60% Porosität): 200 mA/cm² Ätzstromdichte, Einwirkbereich der Elektroden in Transportrichtung 5 cm, Vorschubgeschwindigkeit 60 cm/min, Elektrolyt 50% Ethanol + 50% Flusssäure

Wie beim erfindungsgemäßen Verfahren mit einer Ätzeinheit können auch hier durch Variation des Ätzsstroms beim Ein- und Ausfahren die Schichteigenschaften konstant gehalten werden, oder durch eine Pendelbewegung über beide Ätzeinheiten Mehrfachschichten jeweils gleicher oder unterschiedlicher Eigenschaften erzeugt werden.

Ebenso kann durch die Mehrfachanordnung von Ätzeinheiten bei gleichen Ätzparametern der Durchsatz der Vorrichtung bei gleicher Schichtdicke erhöht werden, oder die Schicht bei gleichem Durchsatz dicker hergestellt werden.

Zu diesen Zwecken kann die erfindungsgemäße Vorrichtung auch mit mehr als zwei Ätzeinheiten ausgestattet werden, z.B. zur Herstellung von optischen Bragg-Reflektoren mit z.B. 16 Einheiten.

Eine bevorzugte Erweiterung der erfindungsgemäßen Vorrichtung mit den Ätzeinheiten vor- und nachgelagerten funktionellen Einheiten zeigt die Fig. 5. In Transportrichtung vor den Ätzeinheiten (1,2,5,6) ist beispielsweise eine Einheit 9 zur Reinigungsätze des Werkstücks angeordnet, sowie in Transportrichtung nach den Ätzeinheiten eine z.B. mit deionisiertem Wasser arbeitende Spüleinheit 11 zur Dekontamination des Werkstücks, eine Trocken- und Reorganisationseinheit 13 zur Trocknung des Werkstücks und zur Reorganisation der porösen Silicium-Mehrfachschicht, sowie eine weitere Einheit 14 zum Ablösen der dünnen Siliciumschicht. Ein entsprechender Prozess kann folgendermaßen durchgeführt werden:
Die Reinigungseinheit 9 wird mit einer polierenden Siliciumätze, z.B. einer Mischung aus Salpetersäure, Flusssäure und deionisiertem Wasser befüllt, und mit einer Pumpe im Überlauf betrieben. Gegebenenfalls kann eine Spülvorrichtung mit deionisiertem Wasser der Siliciumätze nachgeschaltet sein, so dass das Werkstück beim Eintritt in die nachfolgenden porösen Silicium Ätzeinheiten eine saubere Oberfläche aufweist.

Die Spülvorrichtung 11 kann als Sprühspüler mit deionisiertem Wasser ausgeführt werden. Die Trocken- und Ablöseeinheit 13 kann z.B. mit einer auf Halogenlampen oder Quarzstrahlern beruhenden Heizeinheit ausgestattet sein. Zur Erzeugung einer reduzierenden Atmosphäre kann die Einheit eine Spülvorrichtung mit Wasserstoff-haltigem Gas (z.B. 5% Wasserstoff in Argon, oder 100% Wasserstoff) bereitstellen, beispielsweise indem aus dem Stand der Technik bekannte Gasschleusen am Anfang und Ende der Einheit 13 angeordnet sind, die die Außenatmosphäre von der in der Einheit 13 vorhandenen reduzierenden Atmosphäre trennen. Die Ablöseeinheit ist am dem Werkstück zugewandten Segment mit einem Unterdruck von z.B. 100 mbar ausgestattet, und rotiert in der gleichen Umfangsgeschwindigkeit wie die Transportgeschwindigkeit 8.

Das Werkstück wird zunächst über die Reinigungseinheit 9 transportiert, wobei eventuell vorhandener Kristallschaden, oder Reste des vorangegangenen Prozesses entfernt werden. Das Werkstück wird in der integrierten Spülvorrichtung mit deionisiertem Wasser dekontaminiert. Durch Überfahren der Ätzeinheiten (1,2,5,6), die beispielsweise mit den Parametern der unter Fig. 4 beschriebenen Vorrichtung betrieben werden, wird eine Ablöseschicht erzeugt. Das kontaminierte Werkstück wird über die Spüleinheit 11 geführt, und durch besprühen mit deionisiertem Wasser dekontaminiert. Das nasse Werkstück wird im kontinuierlichen Vorschub in der Trocken- und Reorganisationseinheit durch Luft-/Gasströmung und Wärmeeinwirkung zunächst getrocknet. Bei hoher Temperatur wird die poröse Siliciumschicht reorganisiert, und dadurch die Ablösefähigkeit hergestellt. Beim Überfahren der Ablöseeinheit wird die Schicht durch mechanische Einwirkung, z.B. durch Ansaugen mit Unterdruck, von dem Werkstück abgelöst und einer geeigneten Weiterbehandlung (in Fig. 5 nicht gezeigt, z.B. Aufrollen, Aufkleben auf Trägersubstrate, Ablegen auf elektrostatische temporäre Substrate...) zugeführt. Das Werkstück kann daraufhin wieder zurück zum Ausgangspunkt transportiert und erneut dem Prozess zugeführt werden.

Mögliche Prozessparameter für diesen Prozess sind:
- Transportgeschwindigkeit 8: 60 cm/min
- Eingriffslänge der Reinigungseinheit 9: 100 cm, ergibt z.B. eine Ätzzeit von 1 min und eine Spülzeit von 40 s
- Eingriffslänge der Spüleinheit 11: 40 cm, ergibt eine Spülzeit von 40 s
- Trocken- und Reorganisationseinheit: Eingriffslänge 240 cm, davon je 60 cm Aufheiz-/Abkühlzone und 120 cm Reorganisationszone, ergibt eine Aufheizzeit von 1 min, eine Reorganisationszeit von 2 min, eine Abkühlzeit von 1 min. Temperatur in der Reorganisationszone 1200°C (gemessen in der porösen Siliciumschicht), Atmosphäre im beheizten Bereich 100% Wasserstoff

Fig. 6 zeigt als weitere bevorzugte Ausprägung eine erfindungsgemäße Vorrichtung mit einem zylindrischen, rotierenden Werkstück, welche mit vor- und nachgelagerten funktionellen Einheiten bestückt ist. Das Werkstück 3, z.B. ein zylindrischer Silicium-Einkristall, ist so gelagert, dass er um seine Längsachse rotieren kann. Die Anode 4 ist so ausgeführt, dass sie an der Oberfläche des Kristalls keine Schäden hinterlässt, die die poröse Siliciumschicht beeinträchtigen können. Sie kann z.B. als Schleifkontakt an den Stirnflächen des Kristalls, als abrollender Kontakt auf der Umfangsfläche, oder als mitrotierender oder schleifender Kontakt in einer Bohrung entlang der Längsachse des Kristalls ausgeführt sein. Die Ätzeinheiten sind entlang der Umfangsfläche des Kristalls angeordnet, durch geeignete Überlauf- oder Dichtelemente wird der Elektrolyt definiert mit der Kristalloberfläche / Umfangsfläche in Kontakt gebracht. In Transport-/Rotationsrichtung 8 folgt eine Spüleinheit 11 (z.B. ausgeführt als Sprühspüler mit Absaugung) zur Dekontamination, sowie eine Trocken- und Reorganisationseinheit 13 zur Trocknung und Reorganisation der porösen Siliciumschicht. Mit einer Ablöseeinheit 14 kann die reorganisierte Schicht z.B. durch mechanische Einwirkung kontinuierlich abgelöst werden. Mit einer in Transportrichtung nach der Ablöseinheit 14 angeordneten Ätz- und Spüleinheit 10 kann die Oberfläche des Werkstücks für den porösen Silicium-Ätzprozess konditioniert werden.

Änderungen des Kristalldurchmessers können durch adaptive Elektrodenabstände und Anpassungen der Abstände der funktionalen Einheiten inkl. Ätzeinheiten kompensiert werden.

Ein mit dieser Vorrichtung mögliches Verfahren kann folgendermaßen durchgeführt werden:
Als Werkstück dient eine an der Oberfläche möglichst gleichmäßig, z.B. auf 0,01 mm genau abgeschliffener und vom Kristallschaden befreiter Siliciumzylinder, der mittig eine Bohrung enthält und in der eine Achse zur mechanischen Lagerung als auch als Anodenkontakt eingesetzt ist. Die porösen Silicium-Ätzeinheiten sind mit Elektrolyt gefüllt, und werden mit einer Pumpe im Überlauf betrieben. Die Spülvorrichtungen 11, die Trocken- und Reorganisationseinheit 13 und die Ablöseeinheit 14 werden mit ihren Parametern betrieben. Die Ätzeinheit 10 ist bereit zur Füllung mit einer polierenden Siliciumätze, sie wird im Prozess im Überlauf betrieben.

Durch die Transportvorrichtung 8 wird der Kristall mit einer Umfangsgeschwindigkeit von 20 cm/min in Bewegung versetzt, gleichzeitig werden die Ätzströme aktiviert. In den Ätzeinheiten entsteht eine poröse Doppellagenschicht, die bei weiterer kontinuierlicher Rotation in der Spüleinheit dekontaminiert wird und in der Trocken- und Reorganisationseinheit 13 getrocknet und reorganisiert wird. Mit der Ablöseeinheit 14 wird durch mechanische Einwirkung die Schicht abgelöst und der weiteren Verwendung zugeführt. Sobald der Übergangsbereich der Kristalloberfläche zwischen nativer Kristalloberfläche und Überresten der porösen Siliciumschicht zur Konditionierungseinheit 10 gelangt, wird diese gefüllt und dadurch die Kristalloberfläche zur weiteren Ätze rekonditioniert. Nachfolgend wird die Kristalloberfläche in der Spülvorrichtung 11 zwischen der Konditionierungseinheit 10 und der ersten Ätzeinheit 6 dekontaminiert. Bei dauerhafter Rotation kann ein quasi Endlosband von kristallinem Silicium abgelöst werden.

Mögliche Prozessparameter für diesen Prozess sind:
- Transportgeschwindigkeit 8 (Umfangsgeschwindigkeit): 20 cm/min
- Eingriffslänge der Reinigungseinheit 9: 10 cm, ergibt eine Ätzzeit von 30 s
- Eingriffslänge der Spüleinheiten 11: 10 cm, ergibt eine Spülzeit von 30 s
- Trocken- und Reorganisationseinheit: Eingriffslänge 20 cm, ergibt eine Prozesszeit von 1 min. Temperatur in der Reorganisationszone 1200°C (gemessen in der porösen Siliciumschicht), Atmosphäre im beheizten Bereich 100% Wasserstoff
- Ätzkammer 1 (für eine niederporöse Schicht, ca. 30% Porosität): 10 mA/cm² Ätzstromdichte, Einwirkbereich der Elektroden in Transportrichtung 20 cm, Elektrolyt 50% Ethanol + 50% Flusssäure
- Ätzkammer 2 (für eine hochporöse Schicht, ca. 60% Porosität): 200 mA/cm² Ätzstromdichte, Einwirkbereich der Elektroden in Transportrichtung 2 cm, Elektrolyt 50% Ethanol + 50% Flusssäure

### Liste der Bezugszeichen in den Figuren:

1: Stromquelle / Kathodenkontakt
2: Kathode
3: Silicium Werkstück
4: Anode / Anodenkontakt
5: Elektrolyt
6: Ätzbehälter
7: Transporteinheit
8: Transportrichtung
9: Ätzbecken
10: Konditionierungsätze
11: Spüleinheit
12: Deionisiertes Wasser - Sprüh- / oder Überlaufspüler
13: Trocken- und Reorganisationseinheit
14: Ablöseeinheit

## Patentansprüche

1. Vorrichtung zur kontinuierlichen Herstellung poröser Siliciumschichten auf Werkstücken (3) aus Silicium oder einem Werkstück (3) mit einer Silicium-Beschichtung mittels einseitigem Ätzen enthaltend
- mindestens eine Transportvorrichtung (7) für den kontinuierlichen Transport des Werkstücks (3),
- mehr als eine einen Elektrolyten (5) und eine Kathode (2) enthaltende Ätzkammer (6), die so angeordnet sind, dass nur eine zu ätzende Oberfläche des Werkstücks (3) mit dem Elektrolyten (5) benetzbar ist, sowie
- eine mit dem Werkstück (3) an einer nicht zu ätzenden Oberfläche über eine Kontakteinheit elektrisch kontaktierte Anode (4),
wobei die Ätzkammern (6) unterhalb des Werkstücks (3) angeordnet sind.

2. Vorrichtung nach Anspruch 1,
**dadurch gekennzeichnet, dass** die Kathode (2) ausgewählt ist aus der Gruppe bestehend aus flächigen Elektroden, Elektrodendrahtnetze, einzelne Elektrodendrähte oder Kombinationen hiervon, wobei das Material der Kathode (2) bevorzugt aus Platin, Nickellegierungen und/oder Glaskohlenstoff besteht, wobei der Abstand der mindestens einen Kathode (2) zur zu ätzenden Oberfläche des Werkstücks (3) vorzugsweise im Bereich von 1 bis 500 mm, bevorzugt 10 bis 100 mm liegt.

3. Vorrichtung nach einem der vorhergehenden Ansprüche,
**dadurch gekennzeichnet, dass** die mindestens eine Anode als Schleifkontakt, abrollender oder mitlaufender Kontakt ausgebildet ist, wobei das Material der mindestens einen Anode (4) bevorzugt aus Platin, Nickellegierungen, korrosionsfestem Edelstahl, Titan, Aluminium, Graphit und/oder Glaskohlenstoff besteht, wobei die Kontakteinheit der mindestens einen Anode (4) vorzugsweise mit Schutzgas gespült wird, bevorzugt mit Luft oder N₂, so dass das freiliegende Kontaktmaterial nicht mit Elektrolyt- oder Reaktionsdämpfen in Verbindung kommt.

4. Vorrichtung nach einem der vorhergehenden Ansprüche,
**dadurch gekennzeichnet, dass** die Vorrichtung mit Konditionierungseinheiten (10) oder Nachbehandlungseinheiten (11, 13, 14), insbesondere zur Oberflächenbehandlung, zum Spülen oder zum Trocknen gekoppelt ist.

5. Vorrichtung nach einem der vorhergehenden Ansprüche,
**dadurch gekennzeichnet, dass** die Vorrichtung mit einer Einheit (13) zur thermischen Reorganisation der porösen Siliciumschicht gekoppelt ist, die vorzugsweise eine Temperatur- oder Leistungssteuerung für das Tempern des Werkstücks (3) sowie eine Vorrichtung zur Erzeugung einer kontrollierten Gasatmosphäre zumindest auf den beheizten Teilen der Frontseite, bevorzugt realisiert durch Gasschleusen, aufweist, wobei die Einheit (13) zur thermischen Reorganisation vorzugsweise flächige oder fokussierte Lampen zur Einstellung der für die Reorganisation erforderlichen Temperatur in der porösen Siliciumschicht aufweist, wobei die Lampen bevorzugt ausgewählt sind aus der Gruppe der Halogenlampen, LED-Lampen oder Halbleiterlaser.

6. Vorrichtung nach einem der vorhergehenden Ansprüche,
**dadurch gekennzeichnet, dass** das Werkstück (3) eine planare Scheibe, insbesondere aus Silicium, mit einer Frontseite und einer Rückseite ist und die Transportvorrichtung (7) einen horizontalen Transport der planaren Scheibe bewirkt, wobei die zu ätzende Oberfläche die Frontseite der planaren Scheibe ist und die nicht im Kontakt mit dem Elektrolyten (5) stehende Rückseite über die Kontakteinheit mit der Anode (4) elektrisch kontaktiert ist, wobei die mindestens eine Transportvorrichtung (7) vorzugsweise ausgewählt ist aus der Gruppe bestehend aus Rollentransport, Luft-/Flüssigkeitskissentransport oder Durchschubtransport.

7. Vorrichtung nach einem der Ansprüche 1 bis 4,
**dadurch gekennzeichnet, dass** das Werkstück (3) ein Zylinder ist, insbesondere ein Silicium-Ingot, und die Transportvorrichtung (7) eine Rotation des Zylinders bewirkt, wobei die zu ätzende Oberfläche die Mantelfläche des Zylinders ist und der Zylinder an einer nicht zu ätzenden Oberfläche über die Kontakteinheit mit der Anode (4) elektrisch kontaktiert ist, wobei die Kathode (2) vorzugsweise eine konkave Oberfläche aufweist und die Krümmung der konkaven Oberfläche der Kathode (2) an die Krümmung der Manteloberfläche des Zylinders so angepasst ist, dass die Kathode (2) einen einheitlichen Abstand zur Manteloberfläche des Zylinders aufweist.

8. Verfahren zur kontinuierlichen Herstellung poröser Siliciumschichten auf Werkstücken (3) aus Silicium oder Werkstücken (3) mit einer Silicium-Beschichtung mittels einseitigem Ätzen, bei dem mindestens ein Werkstück (3) mittels mindestens einer Transportvorrichtung (7) mit der zu ätzenden Oberfläche des Werkstücks (3) an mehr als einer einen Elektrolyten (5) und eine Kathode (2) enthaltenden Ätzkammer (6) vorbeigeführt wird, wobei nur die zu ätzende Oberfläche mit dem Elektrolyten (5) benetzt wird und das Werkstück (3) an einer nicht zu ätzenden Oberfläche über eine Kontakteinheit mit einer Anode (4) elektrisch kontaktiert wird, wodurch ein elektrochemisches Ätzen der Oberfläche ermöglicht wird, wobei die Ätzkammern (6) unterhalb des Werkstücks (3) angeordnet sind.

9. Verfahren nach Anspruch 8,
**dadurch gekennzeichnet, dass** das elektrochemische Ätzen mit einem Ätzstrom von 0,1 bis 1000 mA/cm², bevorzugt von 5 bis 500 mA/cm² durchgeführt wird.

10. Verfahren nach einem der Ansprüche 8 oder 9,
**dadurch gekennzeichnet, dass** der Elektrolyt (5) Flusssäure und mindestens einen Alkohol oder ein Tensid, insbesondere Ethanol, Acetonitrid, Dimethylsulfoxid, Dimethylacetamid, Dimethylformamid, Formamid, Essigsäure, Gemische aus Tensiden z.B. Siloxanen und Polyalkylenoxidcopolymere, enthält.

11. Verfahren nach einem der Ansprüche 8 bis 10,
**dadurch gekennzeichnet, dass** eine Konvektion des Elektrolyten (5) zur Vermeidung der Blasenbildung erfolgt.

12. Verfahren nach einem der Ansprüche 8 bis 11,
**dadurch gekennzeichnet, dass** das Werkstück (3) aus Silicium oder das Werkstück (3) mit einer Silicium-Beschichtung zur Erzeugung von Elektronen-Fehlstellen ("Löchern") mit Licht bestrahlt wird, wobei das Licht eine Wellenlänge zwischen 200 nm und 1200 nm aufweist, bevorzugt zwischen 400 nm und 1100 nm.

13. Verfahren nach einem der Ansprüche 8 bis 12,
**dadurch gekennzeichnet, dass** das Werkstück (3) eine planare Scheibe, insbesondere eine Silicium-Scheibe mit einer Dicke von 50 µm bis 500 mm, mit einer Fronseite und einer Rückseite ist und der Transport der planaren Scheibe horizontal erfolgt, wobei die Frontseite der planaren geätzt wird und die planare Scheibe in einem nicht zu ätzenden Bereich über die Kontakteinheit mit der Anode (4) elektrisch kontaktiert wird oder dass das Werkstück (3) ein Zylinder ist, insbesondere ein Silicium-Ingot, und die Transportvorrichtung (7) eine Rotation des Zylinders bewirkt, wobei die zu ätzende Oberfläche die Mantelfläche des Zylinders ist und der Zylinder an einer nicht zu ätzenden Oberfläche über die Kontakteinheit mit der Anode (4) elektrisch kontaktiert wird.

14. Verfahren nach einem der Ansprüche 8 bis 13,
**dadurch gekennzeichnet, dass** eine Vorrichtung nach einem der Ansprüche 1 bis 10 eingesetzt wird.

15. Verwendung der Vorrichtung nach einem der Ansprüche 1 bis 7 zur Herstellung von PV-Zellen oder Elektroden für Si-Li-Batterien oder Si-Luft-Batterien.

## Claims

1. Device for continuous production of porous silicon layers on workpieces (3) made of silicon or on a workpiece (3) with a silicon coating by means of one-sided etching, comprising:
- at least one transport device (7) for continuous transport of the workpiece (3),
- more than one etching chamber (6) comprising an electrolyte (5) and a cathode (2) which are disposed such that only one surface of the workpiece (3) to be etched can be made wet with the electrolyte (5), and also,
- an anode (4) which is contacted electrically with the workpiece (3) via a contact unit on a surface not to be etched,
wherein the etching chambers (6) are disposed below the workpiece (3).

2. Device according to claim 1,
**characterised in that** the cathode (2) is selected from the group consisting of planar electrodes, electrode wire netting, individual electrode wires or combinations hereof, the material of the cathode (2) consisting preferably of platinum, nickel alloys and/or glassy carbon, wherein the spacing of the at least one cathode (2) relative to the surface of the workpiece (3) to be etched is preferably in the range of 1 to 500 mm, preferably 10 to 100 mm.

3. Device according to one of the preceding claims,
**characterised in that** the at least one anode is configured as a sliding contact, rolling contact or moving contact, the material of the at least one anode (4) consisting preferably of platinum, nickel alloys, corrosion-resistant stainless steel, titanium, aluminium, graphite and/or glassy carbon, wherein the contact unit of the at least one anode (4) is preferably purged with protective gas, preferably with air or N₂, so that the exposed contact material does not come in contact with electrolyte- or reaction vapours.

4. Device according to one of the preceding claims,
**characterised in that** the device is coupled to conditioning units (10) or posttreatment units (11, 13, 14), in particular for surface treatment, for rinsing or for drying.

5. Device according to one of the preceding claims,
**characterised in that** the device is coupled to a unit (13) for thermal reorganisation of the porous silicon layer, which preferably has a temperature- or power control for temperature-control of the workpiece (3) and also a device for producing a controlled gas atmosphere at least on the heated parts of the front-side, preferably produced by air locks, wherein the unit (13) for thermal reorganisation preferably has planar or focused lamps for adjusting the temperature required for the reorganisation in the porous silicon layer, the lamps being preferably selected from the group of halogen lamps, LED lamps or semiconductor lasers.

6. Device according to one of the preceding claims,
**characterised in that** the workpiece (3) is a planar disc, in particular made of silicon, with a front-side and a rear-side and the transport device (7) effects a horizontal transport of the planar disc, the surface to be etched being the front-side of the planar disc and the rear-side which is not in contact with the electrolyte (5) being contacted electrically with the anode (4) via the contact unit, wherein the at least one transport device (7) is preferably selected from the group consisting of roller transport, air-/fluid cushion transport or sliding transport.

7. Device according to one of the claims 1 to 4,
**characterised in that** the workpiece (3) is a cylinder, in particular a silicon ingot, and the transport device (7) effects rotation of the cylinder, the surface to be etched being the outer surface area of the cylinder and the cylinder being contacted electrically with the anode (4) via the contact unit on a surface not to be etched, wherein the cathode (2) preferably has a concave surface and the curvature of the concave surface of the cathode (2) is adapted to the curvature of the outer surface area of the cylinder such that the cathode (2) has a uniform spacing relative to the outer surface area of the cylinder.

8. Method for continuous production of porous silicon layers on workpieces (3) made of silicon or workpieces (3) with a silicon coating by means of one-sided etching, in which at least one workpiece (3) is guided, by means of at least one transport device (7), with the surface of the workpiece (3) to be etched, past more than one etching chamber (6) comprising an electrolyte (5) and a cathode (2), only the surface to be etched being made wet with the electrolyte (5), and the workpiece (3) being contacted electrically with an anode (4) via a contact unit on a surface not to be etched, as a result of which electrochemical etching of the surface is made possible, wherein the etching chambers (6) are disposed below the workpiece (3).

9. Method according to claim 8,
**characterised in that** the electrochemical etching is implemented with an etching current of 0.1 to 1,000 mA/cm², preferably of 5 to 500 mA/cm².

10. Method according to one of the claims 8 or 9,
**characterised in that** the electrolyte (5) comprises hydrofluoric acid and at least one alcohol or a surfactant, in particular ethanol, acetonitride, dimethylsulphoxide, dimethylacetamide, dimethylformamide, formamide, acetic acid, mixtures of surfactants, e.g. siloxanes and polyalkylene oxide copolymers.

11. Method according to one of the claims 8 to 10,
**characterised in that** convection of the electrolyte (5) is effected in order to avoid formation of bubbles.

12. Method according to one of the claims 8 to 11,
**characterised in that** the workpiece (3) made of silicon or the workpiece (3) with a silicon coating is radiated with light in order to produce electron defects ("holes"), the light having a wavelength between 200 nm and 1,200 nm, preferably between 400 nm and 1,100 nm.

13. Method according to one of the claims 8 to 12,
**characterised in that** the workpiece (3) is a planar disc, in particular a silicon disc with a thickness of 50 µm to 500 mm, with a front-side and a rear-side and transport of the planar disc is effected horizontally, the front-side of the planar disc being etched and the planar disc being contacted electrically with the anode (4) via the contact unit in a region not to be etched, or that the workpiece (3) is a cylinder, in particular a silicon ingot, and the transport device (7) effects rotation of the cylinder, the surface to be etched being the outer surface area of the cylinder and the cylinder being contacted electrically with the anode (4) via the contact unit on a surface not to be etched.

14. Method according to one of the claims 8 to 13,
**characterised in that** a device according to one of the claims 1 to 10 is used.

15. Use of the device according to one of the claims 1 to 7 for the production of PV cells or electrodes for Si-Li batteries or Si-air batteries.

## Revendications

1. Dispositif pour la production en continu de couches de silicium poreuses sur des pièces (3) composées de silicium ou des pièces (3) avec un revêtement de silicium au moyen d'une gravure unilatérale contenant
- au moins un dispositif de transport (7) pour le transport en continu de la pièce (3),
- plus d'une chambre de gravure (6) contenant un électrolyte (5) et une cathode (2), qui sont disposées de sorte que seule une surface à graver de la pièce (3) peut être mouillée avec l'électrolyte (5), ainsi que
- une anode (4) mise en contact électrique avec la pièce (3) par l'intermédiaire d'une unité de contact sur une surface à ne pas graver,
dans lequel les chambres de gravure (6) sont disposées sous la pièce (3).

2. Dispositif selon la revendication 1,
**caractérisé en ce que** la cathode (2) est choisie dans le groupe constitué d'électrodes plates, de réseaux de fils-électrodes, de fils-électrodes individuels ou de combinaisons de ceux-ci, dans lequel le matériau de la cathode (2) est constitué de préférence de platine, d'alliages de nickel et/ou de carbone vitreux, dans lequel la distance de l'au moins une cathode (2) par rapport à la surface à graver de la pièce (3) se situe de préférence dans la plage de 1 à 500 mm, de préférence 10 à 100 mm.

3. Dispositif selon l'une quelconque des revendications précédentes,
**caractérisé en ce que** l'au moins une anode est réalisée en tant que contact frottant, contact roulant ou rotatif,
dans lequel le matériau de l'au moins une anode (4) est constitué de préférence de platine, d'alliages de nickel, d'acier inoxydable résistant à la corrosion, de titane, d'aluminium, de graphite et/ou de carbone vitreux, dans lequel l'unité de contact de l'au moins une anode (4) est rincée de préférence avec un gaz protecteur, de préférence avec de l'air ou du N2, de sorte que le matériau de contact à découvert ne vient pas en liaison avec des vapeurs d'électrolyte ou de réaction.

4. Dispositif selon l'une quelconque des revendications précédentes,
**caractérisé en ce que** le dispositif est lié à des unités de conditionnement (10) ou des unités de post-traitement (11, 13, 14), en particulier pour le traitement de surfaces, pour le rinçage ou pour le séchage.

5. Dispositif selon l'une quelconque des revendications précédentes,
**caractérisé en ce que** le dispositif est lié à une unité (13) pour la réorganisation thermique de la couche de silicium poreuse, qui présente de préférence une commande de température ou de puissance pour le recuit de la pièce (3) ainsi qu'un dispositif pour la production d'une atmosphère gazeuse contrôlée au moins sur les parties chauffées de la face avant, de préférence réalisé par des écluses à gaz, dans lequel l'unité (13) présente pour la réorganisation thermique des lampes de préférence planes ou focalisées pour le réglage de la température nécessaire à la réorganisation dans la couche de silicium poreuse, dans lequel les lampes sont choisies de préférence dans le groupe des lampes halogènes, des lampes à DEL ou des fibres semi-conductrices.

6. Dispositif selon l'une quelconque des revendications précédentes,
**caractérisé en ce que** la pièce (3) est un disque plat, en particulier composé de silicium, avec une face avant et une face arrière et le dispositif de transport (7) effectue un transport horizontal du disque plat, dans lequel la surface à graver est la face avant du disque plat et la face arrière non en contact avec l'électrolyte (5) est mise en contact électrique avec l'anode (4) par l'intermédiaire de l'unité de contact, dans lequel l'au moins un dispositif de transport (7) est choisi de préférence dans le groupe constitué du transport à rouleaux, transport à coussins d'air/de liquide ou transport à glissement.

7. Dispositif selon l'une quelconque des revendications 1 à 4,
**caractérisé en ce que** la pièce (3) est un cylindre, en particulier un lingot de silicium, et le dispositif de transport (7) provoque une rotation du cylindre, dans lequel la surface à graver est la surface d'enveloppe du cylindre et le cylindre est mis en contact électrique avec l'anode (4) par l'intermédiaire de l'unité de contact sur une surface à ne pas graver, dans lequel la cathode (2) présente de préférence une surface concave et la courbure de la surface concave de la cathode (2) est adaptée à la courbure de la surface d'enveloppe du cylindre, de sorte que la cathode (2) présente une distance uniforme par rapport à la surface d'enveloppe du cylindre.

8. Procédé pour la production en continu de couches de silicium poreuses sur des pièces (3) composées de silicium ou sur des pièces (3) avec un revêtement de silicium au moyen d'une gravure unilatérale, dans lequel au moins une pièce (3) est guidé au moyen d'au moins un dispositif de transport (7) avec la surface à graver de la pièce (3)devant plus d'une chambre de gravure (6) contenant un électrolyte (5) et une cathode (2), dans lequel seule la surface à graver est mouillée avec l'électrolyte (5) et la pièce (3) est mise en contact électrique avec une anode (4) par l'intermédiaire d'une unité de contact sur une surface pas à graver, ce qui a pour effet qu'une gravure électrochimique de la surface est permise, dans lequel les chambres de gravure (6) sont disposées sous la pièce (3).

9. Procédé selon la revendication 8,
**caractérisé en ce que** la gravure électrochimique est réalisée avec un courant de gravure de 0,1 à 1 000 mA/cm², de préférence de 5 à 500 mA/cm².

10. Procédé selon l'une quelconque des revendications 8 ou 9,
**caractérisé en ce que** l'électrolyte (5) est de l'acide fluorhydrique et contient au moins un alcool ou un tensioactif, en particulier de l'éthanol, de l'acétonitrile, du diméthylsulfoxyde, du diméthylacétamide, du diméthylformamide, du formamide, de l'acide acétique, des mélanges de tensioactifs par exemple des siloxanes et des copolymères d'oxyde de polyalkylène.

11. Procédé selon l'une quelconque des revendications 8 à 10,
**caractérisé en ce qu'**une convection de l'électrolyte (5) est effectuée pour éviter la formation de bulles.

12. Procédé selon l'une quelconque des revendications 8 à 11,
**caractérisé en ce que** la pièce (3) composée de silicium ou la pièce (3) avec un revêtement de silicium est exposée à de la lumière pour générer des défauts d'électrons (« trous »), dans lequel la lumière présente une longueur d'onde comprise entre 200 nm et 1 200 nm, de préférence entre 400 nm et 1100 nm.

13. Procédé selon l'une quelconque des revendications 8 à 12,
**caractérisé en ce que** la pièce (3) est un disque plat, en particulier un disque en silicium avec une épaisseur de 50 µm à 500 mm, avec une face avant et une face arrière et le transport du disque plat s'effectue horizontalement, dans lequel la face avant du disque plat, est gravée et le disque plat est mis en contact électrique avec l'anode (4) par l'intermédiaire de l'unité de contact dans une zone pas à graver ou que la pièce (3) est un cylindre, en particulier un lingot de silicium, et le dispositif de transport (7) provoque une rotation du cylindre, dans lequel la surface à graver est la surface d'enveloppe du cylindre et le cylindre est mis en contact électrique avec l'anode (4) par l'intermédiaire de l'unité de contact sur une surface pas à graver.

14. Procédé selon l'une quelconque des revendications 8 à 13,
**caractérisé en ce qu'**un dispositif selon l'une quelconque des revendications 1 à 10 est utilisé.

15. Utilisation du dispositif selon l'une quelconque des revendications 1 à 7 pour la production de cellules photovoltaïques ou d'électrodes pour batteries Si-Li ou batteries Si-air.
